# EUROPÄISCHE PATENTANMELDUNG

(11) **EP 1 712 925 A1**
(43) Veröffentlichungstag der Anmeldung: **18.10.2006**
(21) Anmeldenummer: 05007849.2
(22) Anmeldetag: 11.04.2005
(51) Int. Cl.: G01R 31/42, G01R 19/25, G01R 19/165, G01R 29/16, G01R 29/18

(54) **Überwachungsgerät für ein elektrisches Energieversorgungsnetz**

(71) Anmelder: SIEMENS AKTIENGESELLSCHAFT, 80333 München (DE)
(72) Erfinder: Fleischmann, Roland, 91327 Gössweinstein (DE); Harmsen, Peter, 82521 Schwarzenfeld (DE); Kraus, Helmut, 92245 Kümmersbruck (DE); Maier, Martin, 92681 Erbendorf (DE); Spindler, Konrad, 92289 Ursensollen (DE)

(57) **Zusammenfassung**

Die vorliegende Erfindung betrifft ein Netzüberwachungsgerät zur Überwachung eines Versorgungsnetzes, das mindestens drei Phasen (L1,L2,L3) aufweist, mit einer Mess- und Auswerteeinrichtung (M), einer Brückenschaltung (B) und einem Schaltregler (S). Dabei sind die Mess- und Auswerteeinrichtung (M), und die Brückenschaltung (B) mit den drei Phasen (L1,L2,L3) verbunden. Weiterhin ist die Brückenschaltung (B) mit dem Schaltregler (S) so verbunden, dass der Schaltregler (S) eine geregelte Versorgungsspannung für die Mess- und Auswerteeinrichtung (M) bereitstellt.

## Beschreibung

Die vorliegende Erfindung betrifft ein Netzüberwachungsgerät gemäß dem Oberbegriff des Anspruchs 1.

Netzüberwachungsgeräte, auch als Netzüberwachungsrelais bezeichnet, werden heute häufig in der Automatisierungstechnik für die Überwachung von dreiphasigen Versorgungsnetzen eingesetzt. Dabei werden Größen des Versorgungsnetzes, wie beispielsweise Spannung, Strom, Phasenfolge oder daraus ableitbare Größen wie Leistung, Phasenverschiebung, Asymmetrie von einem solchen Netzüberwachungsgerät gemessen und ausgewertet. Weicht eine dieser Größen von den festgelegten Sollwerten ab, muss das Netzüberwachungsgerät diesen Fehler melden.

Heute bekannte Netzüberwachungsgeräte funktionieren in aller Regel nach dem so genannten Ruhestromprinzip. Das bedeutet, dass nach dem Anlegen der Versorgungsspannung ein Melderelais angezogen wird. Bei Auftreten eines Fehlers oder beim Ausfall der Versorgungsspannung fällt dieses Melderelais in den Ruhezustand zurück und meldet damit einen Fehler. Eine detaillierte Anzeige, welcher Fehler zu diesem Schaltvorgang geführt hat, ist dabei aber nicht möglich. Diesem Nachteil kann man dadurch begegnen, dass das Netzüberwachungsgerät mit einer Hilfsspannung betrieben wird. Aus dieser Hilfsspannung die z.B. aus einem eigens abgesicherten Stromzweig kommt, wird die Versorgungsspannung für die Mess- und Auswerteeinrichtung des Netzüberwachungsgerätes gewonnen. Kommt es nun zu einem Fehler auf dem zu überwachenden dreiphasigen Versorgungsnetz, meldet das Netzüberwachungsgerät diesen Fehler durch Betätigen eines beispielsweise nach dem Arbeitsstromprinzip arbeitenden Melderelais. Dadurch ist detailliertere Fehlermeldung möglich. Nachteilig ist hier aber, dass eine vom zu überwachenden Versorgungsnetz abgekoppelte Hilfsspannung erforderlich ist, diese auch verdrahtet werden muss und dass bei Ausfall dieser Hilfsspannung die Mess- und Auswerteeinrichtung nicht funktionsfähig ist.

Aufgabe der vorliegenden Erfindung ist deshalb, ein Netzüberwachungsgerät anzugeben, das sowohl weniger aufwendig aufgebaut ist als auch bei Ausfall einer Phase weiterhin eine sichere Fehlermeldung gewährleistet.

Diese Aufgabe wird gelöst durch das Netzüberwachungsgerät mit den Merkmalen des Anspruchs 1, nämlich einem Netzüberwachungsgerät zur Überwachung eines Versorgungsnetzes, das mindestens drei Phasen aufweist, mit einer Mess- und Auswerteeinrichtung, einer Brückenschaltung und einem Schaltregler,
wobei die Mess- und Auswerteeinrichtung, und die Brückenschaltung mit den drei Phasen verbunden sind und wobei die Brückenschaltung mit dem Schaltregler so verbunden sind, dass der Schaltregler eine geregelte Versorgungsspannung für die Mess- und Auswerteeinrichtung bereitstellt.

Dadurch ist die Mess- und Auswerteeinrichtung des erfindungsgemäßen Netzüberwachungsgerätes eigenversorgt, das heißt, die Mess- und Auswerteeinrichtung des Netzüberwachungsgerätes bezieht seine Versorgungsspannung aus dem zu überwachenden Versorgungsnetz selbst, wodurch eine aufwendige Beschaltung mit Hilfsspannung entfallen kann und trotzdem noch eine detaillierte Fehlermeldung erfolgen kann.

Weitere vorteilhafte Ausführungen und bevorzugte Weiterbildungen der Erfindung sind den Unteransprüchen zu entnehmen.

Die Erfindung sowie vorteilhafte Ausführungsbeispiele derselben werden im Weiteren anhand der nachfolgenden Figur näher beschrieben.

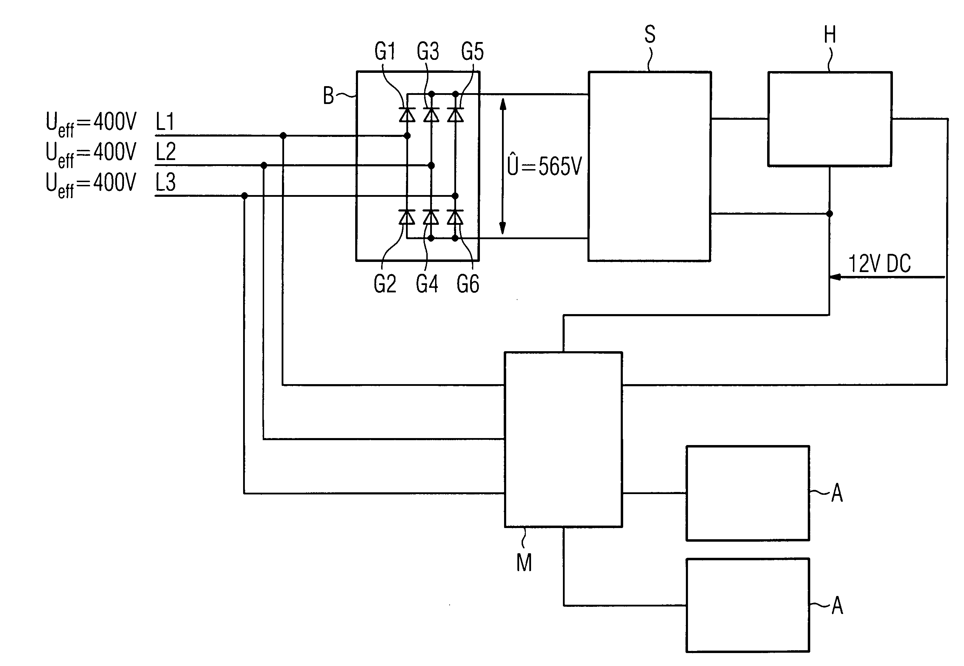

Dabei zeigt FIG 1 einen schematischen Aufbau des erfindungsgemäßen Netzüberwachungsgeräts. Die Mess- und Auswerteeinrichtung M des Netzüberwachungsgerätes ist dabei direkt mit den drei zu überwachenden Phasen L1 bis L3 des Versorgungsnetzes verbunden. Parallel zu dieser Mess- und Auswerteeinrichtung M ist eine Brückenschaltung B an die Phasen L1 bis L3 angeschlossen. Der in FIG 1 dargestellte Aufbau der Brückenschaltung B aus sechs Gleichrichtern G1 - G6 wandelt dabei die Spannung der drei Phasen in eine pulsierende Gleichspannung um. Diese pulsierende Gleichspannung wird anschließend einem Schaltregler S zugeführt. Dieser Schaltregler S erzeugt eine geregelte Ausgangsspannung, die anschließend an eine Hochvoltstufe H geführt wird. Am Ausgang der Hochvoltstufe H liegt dann eine Differenzspannung D an, die so groß ist, dass die Mess- und Auswerteeinrichtung M des Netzüberwachungsgerätes versorgt werden kann. An diese Mess- und Auswerteeinrichtung M können dann optische Anzeige- oder Schaltmittel A zur Fehlermeldung angebracht sein.

Im vorliegenden Beispiel sind die Brückenschaltung B und der Schaltregler S so dimensioniert, dass auch bei einem Ausfall einer der drei Phasen L1 bis L3, die jeweils eine effektive Spannung von 400 V aufweisen, am Versorgungseingang der Mess- und Auswerteeinrichtung M eine nahezu gleichgerichtete Spannung von 12 V anliegt. Diese Spannung ist aufgrund des Schaltreglers eine Differenzspannung auf die am Ausgang der Brückenschaltung anliegenden Spannung von 565 V und damit frei floatend. Durch geeignete Wahl und Dimensionierung der hintereinander geschalteten Brückenschaltung B, Schaltregler S und ggf. Hochvoltstufe H steht somit für die Elektronik der Mess- und Auswerteeinrichtung selbst bei Ausfall einer der drei Phasen L1 bis L3 immer noch genügend Versorgungsspannung zu Verfügung, um die Fehlermeldungsfunktion der Mess- und Auswerteeinrichtung aufrechtzuerhalten.

Die in der FIG 1 dargestellte Hochvoltstufe H dient dabei zum Betrieb des Netzüberwachungsgeräts an hohen Versorgungsspannungen. Sollen niedrigere Phasenspannungen überwacht werden, kann diese Hochvoltstufe H entfallen. Prinzipiell ist so mit einem einzigen erfindungsgemäßen Netzüberwachungsgerät die Überwachung eines größeren Spannungsbereichs des Versorgungsnetzes möglich.

Zusammenfassend ergeben sich für das erfindungsgemäße Netzüberwachungsgerät neben dem wesentlichen Vorteil, dass beim Ausfall einer beliebigen Phase des speisenden Netzes die Gerätefunktionalität voll erhalten bleibt, somit folgende weitere Vorteile:
- Das Mess- und Auswerteeinrichtung M des Netzüberwachungsgerätes ist eigenversorgt aus dem zu überwachenden Netz. Es ist demzufolge keine Hilfsspannung mit zugehöriger Verdrahtung mehr erforderlich.
- Der erfindungsgemäße Aufbau ist im Vergleich zu Aufbauten mit Hilfsspannungen Platz und Kosten sparend, da das Transformatornetzteil entfallen kann.
- Durch Verwendung der oben beschriebenen Ausführungsform ist das Gerät in einem weiten Versorgungsspannungsbereich universell einsetzbar und reduziert deshalb Gerätevarianten.
- Ein Bedienungsfehler durch Falschanschluss durch z.B. verschiedene Klemmen für verschiedene Spannungen an einem Gerät ist nicht möglich.
- Das Netzüberwachungsgerät kann sowohl nach dem Arbeitsals auch dem Ruhestromprinzip betrieben werden.

## Patentansprüche

1. Netzüberwachungsgerät zur Überwachung eines Versorgungsnetzes, das mindestens drei Phasen (L1,L2,L3) aufweist, mit einer Mess- und Auswerteeinrichtung (M), einer Brückenschaltung (B) und einem Schaltregler (S),
wobei die Mess- und Auswerteeinrichtung (M), und die Brückenschaltung (B) mit den drei Phasen (L1, L2, L3) verbunden sind und wobei die Brückenschaltung (B) mit dem Schaltregler (S) so verbunden sind, dass der Schaltregler (S) eine geregelte Versorgungsspannung für die Mess- und Auswerteeinrichtung (M) bereitstellt.

2. Netzüberwachungsgerät nach Anspruch 1,
**dadurch gekennzeichnet, dass**
zwischen dem Schaltregler (S) und einem Spannungsversorgungseingang der Mess- und Auswerteeinrichtung (M) eine Hochvoltstufe (H) vorgesehen ist.

3. Netzüberwachungsgerät nach Anspruch 1 oder 2,
**dadurch gekennzeichnet, dass** an die Mess- und Auswerteeinrichtung (M) eine optische Anzeige zur Fehlermeldung anbringbar ist.

4. Netzüberwachungsgerät nach einem der Ansprüche 1 - 3,
**dadurch gekennzeichnet, dass**
an die Mess- und Auswerteeinrichtung (M) ein Schaltmittel zur Fehlermeldung anbringbar ist.
